# EUROPEAN PATENT SPECIFICATION

(11) **EP 1 999 230 B1**
(45) Date of publication and mention of the grant of the patent: **13.06.2012**
(21) Application number: 07751816.5
(22) Date of filing: 26.02.2007
(51) Int. Cl.: C09K 11/08, C09K 11/61

(54) **RED LINE EMITTING PHOSPHORS FOR USE IN LED APPLICATIONS**
ROTLINIENEMITTIERENDE LEUCHTSTOFFE FÜR LED-ANWENDUNGEN
PHOSPHORES ÉMETTEURS DE RAIE ROUGE UTILISABLES DANS DES APPLICATIONS À DEL

(30) Priority: 28.02.2006 US 364611
(43) Date of publication of application: 10.12.2008
(73) Proprietor: GE Lighting Solutions, LLC, Cleveland, Ohio 44112 (US)
(72) Inventor: RADKOV, Emil, Vergilov, Euclid, OH 44132 (US); GRIGOROV, Ljudmil, Slavchev, 1000 Sofia (BG); SETLUR, Anant, Achyut, Niskayuna, NY 12309 (US); SRIVASTAVA, Alok, Mani, Niskayuna, NY 12309 (US)
(74) Representative: Simcox, Michael Thomas
(86) International application number: PCT/US2007/005083
(87) International publication number: WO 2007/100824

(56) References cited:
- EP-A- 1 403 355
- US-A1- 2005 253 114
- A.G.PAULUSZ: "Efficient Mn(IV) Emission in Fluorine Coordination" J. OF THE ELECTOCHEMICAL SOC., vol. 120, no. 7, July 1973 (1973-07), pages 942-947, XP002447600 USA

## Description

### BACKGROUND

The present exemplary embodiments relate to phosphor compositions, particularly phosphors for use in lighting applications. More particularly, the present embodiments relate to red emitting phosphors and a lighting apparatus employing these phosphors.

Red line emitting phosphors doped with Eu³⁺ are known in the art, and are used in a wide range of display and general lighting applications (TV screens, triphosphor fluorescent lamps, etc.). Oxyfluoride red line emitting phosphors doped with Mn⁴⁺ are also known e.g. in specialty lighting applications, such as low and high-pressure mercury discharge lamps with improved color rendering.

Light emitting diodes (LEDs) are semiconductor light emitters often used as a replacement for other light sources, such as incandescent lamps. They are particularly useful as display lights, warning lights and indicator lights or in other applications where colored light is desired. The color of light produced by an LED is dependent on the type of semiconductor material used in its manufacture.

Colored semiconductor light emitting devices, including light emitting diodes and lasers (both are generally referred to herein as LEDs), have been produced from Group III-V alloys such as gallium nitride (GaN). With reference to the GaN-based LEDs, light is generally emitted in the UV to green range of the electromagnetic spectrum. Until quite recently, LEDs have not been suitable for lighting uses where a bright white light is needed, due to the inherent color of the light produced by the LED.

Recently, techniques have been developed for converting the light emitted from LEDs to useful light for illumination purposes. In one technique, the LED is coated or covered with a phosphor layer. A phosphor is a luminescent material that absorbs radiation energy in a portion of the electromagnetic spectrum and emits energy in another portion of the electromagnetic spectrum. Phosphors of one important class are crystalline inorganic compounds of very high chemical purity and of controlled composition to which small quantities of other elements (called "activators") have been added to convert them into efficient fluorescent materials. With the right combination of activators and inorganic compounds, the color of the emission can be controlled. Most useful and well-known phosphors emit radiation in the visible portion of the electromagnetic spectrum in response to excitation by electromagnetic radiation outside the visible range.

By interposing a phosphor excited by the radiation generated by the LED, light of a different wavelength, e.g., in the visible range of the spectrum, may be generated. Colored LEDs are often used in toys, indicator lights and other devices. Continuous performance improvements have enabled new applications for LEDs of saturated colors in traffic lights, exit signs, store signs, and the like.

In addition to colored LEDs, a combination of LED generated light and phosphor generated light may be used to produce white light. The most popular white LEDs consist of blue emitting GalnN chips. The blue emitting chips are coated with a phosphor that converts some of the blue radiation to a complementary color, e.g. a yellowish emission. Together, the blue and yellowish radiation produces a white light. There are also white LEDs that utilize a near UV emitting chip and a phosphor blend including red, green and blue emitting phosphors designed to convert the UV radiation to visible light.

Known white light emitting devices comprise a blue light-emitting LED having a peak emission wavelength in the near blue range (from about 440 nm to about 480 nm) combined with a yellow light-emitting phosphor, such as cerium(III) doped yttrium aluminum garnet ("YAG:Ce"), a cerium(III) doped terbium aluminum garnet ("TAG:Ce"), or a europium(II) doped barium silicate ("BOS"). The phosphor absorbs a portion of the radiation emitted from the LED and converts the absorbed radiation to a yellow light. The remainder of the blue light emitted by the LED is transmitted through the phosphor and is mixed with the yellow light emitted by the phosphor. A viewer perceives the mixture of blue and yellow light as a white light. The total of the light from the phosphor material and the LED chip provides a color point with corresponding color coordinates (x and y) and correlated color temperature (CCT), and its spectral distribution provides a color rendering capability, measured by the color rendering index (CRI).

Such systems can be used to make white light sources having CCTs of >4500 K and CRIs ranging from about 70-82, with luminous efficacy of radiation ("LER", also referred to as luminosity) of about 330 Im/Wₒₚₜ. While this range is suitable for many applications, general illumination sources usually require lower CCTs and higher CRIs, preferably with similar or better LER.

One particularly preferred application of white LED devices made from blue emitting chips and yellow emitting phosphors is for backlights, e.g. in cellular phones, personal digital assistants, and the like. These applications require high CCT values (greater than 5000K), which are readily provided by the aforementioned LEDs, with LER values of 280 Im/Wₒₚₜ or greater. However, due to the use of yellow phosphors (e.g. having a peak emission between 550 nm and 610 nm), the spectra of these LEDs contain excessive emission in the yellow region of the spectrum, which strongly reduces the color gamut of the backlight.

The color gamut of any display apparatus is the area spanned between the color points of the red, green and blue pixels of the display in a chromaticity diagram, e.g. the CIE 1931 x, y diagram. The historical "golden standard" for displays is the NTSC gamut, defined by 3 sets of color point coordinates (x=0.674 and y=0.326 for red, x=0.218 and y=0.712 for green, and x=0.140 and y=0.080 for blue in the CIE 1931 x,y chromaticity diagram). Generally, a gamut greater than 70% of NTSC is considered acceptable for many backlighting applications, and a gamut greater than 90% of NTSC is considered acceptable for most any such application.

In order to improve the gamut of LED backlights using yellow phosphors, the yellow light is filtered out, thereby reducing the effective LER of the LED backlight. It would be therefore beneficial to develop LED backlights that can provide LER of 280 Im/Wₒₚₜ or greater at CCT>5000K without having yellow phosphors in the package. Red line-emitting phosphors would be particularly suitable for obtaining simultaneously such values for LER and CCT when used with blue or near-UV LED chips, in conjunction with at least a green-emitting and a blue-emitting phosphor, as needed.

Other white light LED lighting systems use a UV or visible light LED chip along with a blend of red, green, and/or blue phosphors that can be efficiently excited by near-UV radiation to make white tight.

The CRI is commonly defined as a mean value for 8 standard color samples (R₁₋₈), usually referred to as the General Color Rendering Index and abbreviated as Rₐ, although 14 standard color samples are specified internationally and one can calculate a broader CRI (R₁₋₁₄) as their mean value. In particular, the R₉ value, measuring the color rendering for the strong red, is very important for a range of applications, especially of medical nature.

As the CCT is lowered and/or the CRI is increased, the LER value generally decreases, leading to values for "warm white" LEDs (of CCT<4500K) significantly lower than those for "cool white" LEDs (of CCT>4500K). The LER value of any light source (including LEDs) can be improved by using red phosphors having a line emission spectrum, as opposed to red phosphors with a broadband emission. A significant portion of the emitted energy of the latter phosphors tends to fall into the deep red part of the spectrum where the sensitivity of the human eye is very low, thereby decreasing the LER value.

In many lighting applications known in the art, phosphors with line emission spectra (e.g. Y₂O₃: Eu³⁺) are thus preferred as the red component because it maximizes LER at acceptable CRI values (e.g. 80-86), over the CCT range of interest (e.g. 3000-6500K). Current red fluorescent lamp phosphors doped with Eu³⁺ cannot be used successfully in UV LED lamps because they have virtually no absorption of near-UV (370-420 nm) light, leading to unacceptable light loss due to scattering by the phosphor. A deep red line emitting oxyfluoride phosphor, e.g. 3.5MgO*0.5MgF₂*GeO₂:Mn⁴⁺ (MFG) can be used in LED lamps, but with considerable impact to LER, due to much of its emission occurring too far in the red region of the spectrum (beyond 650 nm). Other similar phosphors based on oxide and oxyhalide host lattices doped with Mn⁴⁺ also have a main emission peak at a wavelength greater than 650 nm. It would be preferable to use red phosphors with line emission maxima at lower wavelengths, e.g. in the 610 to 650 nm range, capable of converting at least part of the radiation from the light source, e.g. an LED chip emitting in the UV to blue range. This improves the LER while maintaining the general CRI at 80 or above.

Thus, a continuing need exists for new red line-emitting phosphors and their blends for use in display or lighting applications, particularly in conjunction with UV and visible LED chips displaying high quantum efficiency to produce white-light sources having both a high CRI and an improved LER at any given CCT, as well as backlights with minimal yellow emission and high LER.

### BRIEF SUMMARY

In a first aspect, there is provided a backlight emitting apparatus including a semiconductor light source; wherein the backlight comprises a red line-emitting phosphor having a peak emission wavelength between 610 and 650 nm; a green emitting phosphor having a peak emission wavelength between 510 and 550 nm; and either a) a blue LED chip having a peak emission wavelength between 440 and 480 nm, or b) a blue emitting phosphor having a peak emission wavelength between 440 and 480 nm and a violet to near-UV emitting LED chip having a peak emission wavelength from about 370 nm to about 440 nm. In a particular embodiment, a complex fluoride phosphor material activated with Mn⁴⁺ is used as the red line-emitting phosphor.

In a second aspect, there is provided a light emitting apparatus including a light source and a complex fluoride phosphor material activated with Mn⁴⁺. In one embodiment, the complex fluoride phosphor may comprise at least one of: (A) A₂[MF₅]:Mn⁴⁺, where A is selected from Li, Na, K, Rb, Cs, NH₄, and combinations thereof; and where M is selected from Al, Ga, In, and combinations thereof; (B) A₃[MF₆]:Mn⁴⁺, where A is selected from Li, Na, K, Rb, Cs, NH₄, and combinations thereof; and where M is selected from Al, Ga, In, and combinations thereof; (C) Zn₂[MF₇]:Mn⁴⁺, where M is selected from Al, Ga, In, and combinations thereof; (D) A[In₂F₇]:Mn⁴⁺ where A is selected from Li, Na, K, Rb, Cs, NH₄, and combinations thereof; (E) A₂[MF₆]:Mn⁴⁺, where A is selected from Li, Na, K, Rb, Cs, NH₄, and combinations thereof; and where M is selected from Ge, Si, Sn, Ti, Zr, and combinations thereof; (F) E[MF₆]:Mn⁴⁺, where E is selected from Mg, Ca, Sr, Ba, Zn, and combinations thereof; and where M is selected from Ge, Si, Sn, Ti, Zr, and combinations thereof; (G) Ba₀.₆₅Zr₀.₃₅F₂.₇₀:Mn⁴⁺; or (H) A₃[ZrF₇]:Mn⁴⁺ where A is selected from Li, Na, K, Rb, Cs, NH₄, and combinations thereof.

In a third aspect, there is provided a phosphor blend including at least one of the above complex fluoride phosphors activated with Mn⁴⁺ and at least one additional phosphor.

In a fourth aspect, there is provided a phosphor material including at least one of: (A) A₂[MF₆]:Mn⁴⁺, where A is selected from Li, Na, K, Rb, Cs, NH₄, and combinations thereof; and where M is selected from Sn, Zr, and combinations thereof; (B) E[MF₆]:Mn⁴⁺, where E is selected from Mg, Ca, Sr, Ba, Zn, and combinations thereof; and where M is selected from Ge, Si, Sn, Ti, Zr, and combinations thereof; (C) Ba_{0.65}Zr₀.₃₅F_{2.70}:Mn⁴⁺; (D) A₃[ZrF₇]:Mn⁴⁺ where A is selected from Li, Na, K, Rb, Cs, NH₄, and combinations thereof; (E) A₂[MF₆]:Mn⁴⁺, where A is selected from at least two among Li, Na, K, Rb, Cs, and NH₄, and where M is selected from Ge, Si, Sn, Ti, Zr, and combinations thereof;

### BRIEF DESCRIPTION OF THE DRAWINGS

FIGURE 1 is a schematic cross-sectional view of an illumination system in accordance with one embodiment of the present invention.

FIGURE 2 is a schematic cross-sectional view of an illumination system in accordance with a second embodiment of the present invention.

FIGURE 3 is a schematic cross-sectional view of an illumination system in accordance with a third embodiment of the present invention.

FIGURE 4 is a cutaway side perspective view of an illumination system in accordance with a fourth embodiment of the present invention.

FIGURE 5 is a graph of the emission spectrum of a Na₂[TiF₆]:Mn⁴⁺ phosphor.

FIGURE 6 is a graph of the emission spectrum of a K₂[SnF₆]:Mn⁴⁺ phosphor.

Figure 7 is a graph of the emission spectrum of a Ba[TiF₆]:Mn⁴⁺ phosphor.

FIGURE 8 is a graph of the emission spectrum of a K₃[ZrF₇]:Mn⁴⁺ phosphor.

FIGURE 9 is the power distribution spectrum of an LED device using a present embodiment phosphor blend.

FIGURE 10 is the power distribution spectrum of a second LED device using a present embodiment phosphor blend.

FIGURE 11 is a graph of the excitation and emission spectra of a K₃[AlF₆]:Mn⁴⁺ phosphor according to an embodiment of the present invention.

FIGURE 12 is an experimental spectral power distribution of a LED using blue chip and a blend of the phosphors K₂[TiF₆]:Mn⁴⁺ and STG.

FIGURE 13 is a graphical representation of the gamuts of the NTSC standard and of a LED using blue chip and a blend of the phosphors K₂[TiF₆]:Mn⁴⁺ and STG in the CIE 1931 x, y chromaticity diagram.

FIGURE 14 is a schematic perspective view of a surface mounted device (SMD) backlight LED.

### DETAILED DESCRIPTION OF THE EXEMPLARY EMBODIMENTS

Phosphors convert radiation (energy) to visible light. Different combinations of phosphors provide different colored light emissions. Novel phosphor compositions and blends are presented herein as well as their use in LED and other light sources.

The color of the generated visible light is dependent on the particular components of the phosphor material. The phosphor material may include only a single phosphor composition or two or more phosphors of basic color, for example a particular mix with one or more of a yellow and red phosphor to emit a desired color (tint) of light. As used herein, the terms "phosphor" and "phosphor material" may be used to denote both a single phosphor composition as well as a blend of two or more phosphor compositions.

It was determined that an apparatus that produces light containing a red line component by using a phosphor material capable of converting at least part of the radiation from a light source into red line emission having a peak wavelength between 610 and 650 nm would be useful e.g. in display or general lighting applications. A highly suitable example of such phosphor material is a complex fluoride phosphor activated with Mn⁴⁺. Referred examples for various embodiments will be provided further below.

One or more additional phosphors can be used in conjunction with the above red line emitting phosphor in the phosphor material. Therefore, in one embodiment, a luminescent conversion material blend (phosphor blend) coated LED chip is disclosed for providing white light. The phosphor blends presented in this embodiment enable white light with an optimal combination of CRI and LER at any CCT of interest, when excited by radiation from about 250 to 550 nm as emitted by a near UV to green LED, either alone or in combination with any residual bleed from the LED.

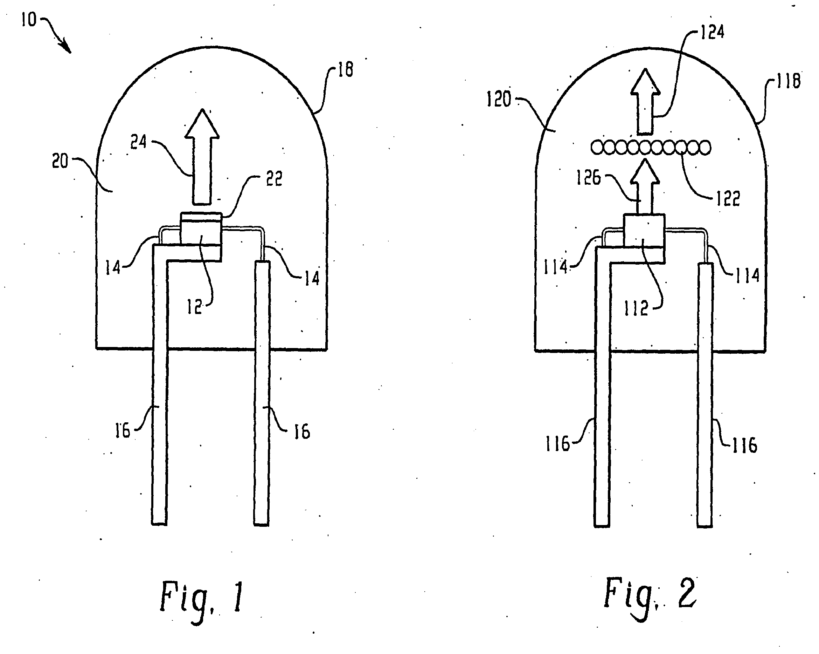

With reference to Figure 1, an exemplary LED based light emitting assembly or lamp 10 is shown in accordance with one preferred structure of the present invention. The light emitting assembly 10 comprises a semiconductor UV or visible radiation source, such as a light emitting diode (LED) chip 12 and leads 14 electrically attached to the LED chip. The leads 14 may comprise thin wires supported by a thicker lead frame(s) 16 or the leads may comprise self-supported electrodes and the lead frame may be omitted. The leads 14 provide current to the LED chip 12 and thus cause the LED chip 12 to emit radiation.

The lamp may include any semiconductor visible or UV light source that is capable of producing white light when its emitted radiation is directed onto the phosphor. The preferred peak emission of the LED chip in the present invention will depend on the identity of the phosphors in the disclosed embodiments and may range from, e.g., 250-550 nm. In one preferred embodiment, however, the emission of the LED will be in the near UV to blue-green region and have a peak wavelength in the range from about 370 to about 500 nm. Typically then, the semiconductor light source comprises an LED doped with various impurities. Thus, the LED may comprise a semiconductor diode based on any suitable III-V, II-VI or IV-IV semiconductor layers and having a peak emission wavelength of about 250 to 550 nm.

Preferably, the LED may contain at least one semiconductor layer comprising GaN, ZnO or SiC. For example, the LED may comprise a nitride compound semiconductor represented by the formula InᵢGaⱼAlₖN (where 0≤i; 0≤j; 0≤k and i+j+k =1) having a peak emission wavelength greater than about 250 nm and less than about 550 nm. Such LED semiconductors are known in the art. The radiation source is described herein as an LED for convenience. However, as used herein, the term is meant to encompass all semiconductor radiation sources including, e.g., semiconductor laser diodes.

Although the general discussion of the exemplary structures of the invention discussed herein are directed toward inorganic LED based light sources, it should be understood that the LED chip may be replaced by an organic light emissive structure or any other radiation source unless otherwise noted and that any reference to LED chip or semiconductor is merely representative of any appropriate radiation source.

The LED chip 12 may be encapsulated within a shell 18, which encloses the LED chip and an encapsulant material 20. The shell 18 may be, for example, glass or plastic. Preferably, the LED 12 is substantially centered in the encapsulant 20. The encapsulant 20 is preferably an epoxy, plastic, low temperature glass, polymer, thermoplastic, thermoset material, resin or other type of LED encapsulating material as is known in the art. Optionally, the encapsulant 20 is a spin-on glass or some other material having a high index of refraction. In one embodiment, the encapsulant material 20 is a polymer material, such as epoxy, silicone, or silicone epoxy, although other organic or inorganic encapsulants may be used. Both the shell 18 and the encapsulant 20 are preferably transparent or substantially optically transmissive with respect to the wavelength of light produced by the LED chip 12 and a phosphor material 22 (described below). In an alternate embodiment, the lamp 10 may only comprise an encapsulant material without an outer shell 18. The LED chip 12 may be supported, for example, by the lead frame 16, by the self supporting electrodes, the bottom of the shell 18, or by a pedestal (not shown) mounted to the shell or to the lead frame.

The structure of the illumination system includes a phosphor material 22 radiationally coupled to the LED chip 12. Radiationally coupled means that the elements are associated with each other so that at least part of the radiation emitted from one is transmitted to the other.

This phosphor material 22 is deposited on the LED 12 by any appropriate method. For example, a suspension of the phosphor(s) can be formed, and applied as a phosphor layer to the LED surface. In one such method, a silicone, epoxy or other matrix material is used (either directly or diluted with an organic solvent, e.g. acetone, MIBK or butyl acetate) to create a slurry in which the phosphor particles are randomly suspended and placed around the LED. This method is merely exemplary of possible positions of the phosphor material 22 and LED 12. Thus, the phosphor material 22 may be coated over or directly on the light emitting surface of the LED chip 12 by coating and drying or curing the phosphor suspension over the LED chip 12. Both the shell 18 and the encapsulant 20 should be transparent to allow light 24 to be transmitted through those elements. Although not intended to be limiting, the median particle size of the phosphor material as measured using light scattering methods or via microscope (electron or optical) measurements may be from about 1 to about 20 microns.

FIG. 2 illustrates a second preferred structure of the apparatus according to the preferred aspect of the present invention. Corresponding numbers from Figures 1-4 (e.g. 12 in Figure 1 and 112 in Figure 2) relate to corresponding structures in each of the figures unless otherwise stated. The structure of the embodiment of FIG. 2 is similar to that of FIG. 1, except that the phosphor material 122 is interspersed within the encapsulant material 120, instead of being formed directly on the LED chip 112. The phosphor material (in the form of a powder) may be interspersed within a single region of the encapsulant material 120 or, more preferably, throughout the entire volume of the encapsulant material. Radiation 126 emitted by the LED chip 112 mixes with the light emitted by the phosphor material 122, and the mixed light appears as white light 124. If the phosphor is to be interspersed within the encapsulant material 120, then a phosphor powder may be added to a polymer precursor, loaded around the LED chip 112, and then the polymer precursor may be cured to solidify the polymer material. Other known phosphor interspersion methods may also be used, such as transfer molding.

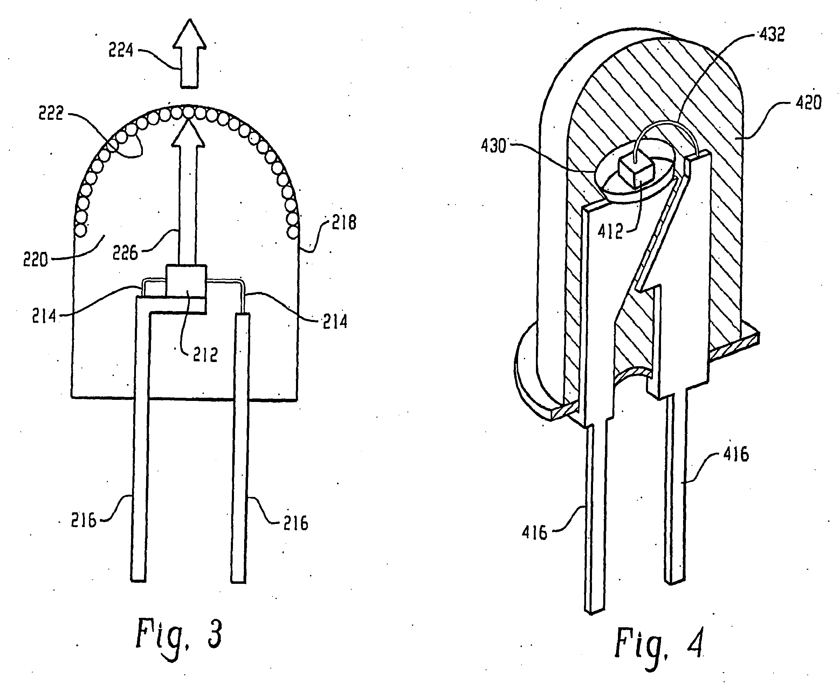

FIG. 3 illustrates a third preferred structure of the apparatus according to the preferred aspects of the present invention. The structure of the embodiment shown in FIG. 3 is similar to that of FIG. 1, except that the phosphor material 222 is coated onto a surface of the shell 218, instead of being formed over the LED chip 212. The phosphor material is preferably coated on the inside surface of the shell 218, although the phosphor may be coated on the outside surface of the shell, if desired. The phosphor material 222 may be coated on the entire surface of the shell or only a top portion of the surface of the shell. The radiation 226 emitted by the LED chip 212 mixes with the light emitted by the phosphor material 222, and the mixed light appears as white light 224. Of course, the structures of FIGS. 1-3 may be combined and the phosphor may be located in any two or all three locations or in any other suitable location, such as separately from the shell or integrated into the LED.

In any of the above structures, the lamp 10 may also include a plurality of scattering particles (not shown), which are embedded in the encapsulant material. The scattering particles may comprise, for example, Al₂O₃ particles (such as alumina powder) or TiO₂ particles. The scattering particles effectively scatter the coherent light emitted from the LED chip, preferably with a negligible amount of absorption.

As shown in a fourth preferred structure in Figure 4, the LED chip 412 may be mounted in a reflective cup 430. The cup 430 may be made from or coated with a reflective material, such as alumina, titania, or other dielectric powder known in the art. A preferred reflective material is Al₂O₃. The remainder of the structure of the embodiment of FIG. 4 is the same as that of any of the previous Figures, and includes two leads 416, a conducting wire 432 electrically connecting the LED chip 412 with the second lead, and an encapsulant material 420.

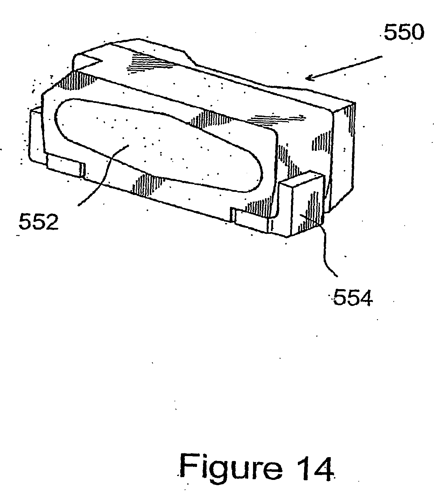

Another preferred structure (particularly for backlight applications) is a surface mounted device ("SMD") type light emitting diode 550, e.g. as shown in FIG. 14. This SMD is of a "side-emitting type" and has a light emitting window 552 on a protruding portion of a light guiding member 554. The SMD type light emitting diodes 550 can be made by disposing LEDs that have been formed beforehand by flow soldering or the like on a glass epoxy substrate, whereon an electrically conductive pattern has been formed and covering said LED with the window 552. There are also "top-emitting" SMD packages known in the art that are also suitable for use in the present embodiments, e.g. those produced by Nichia Corporation. An SMD package may comprise an LED chip as defined above, and a phosphor material as discussed below that is excited by the light emitted from the LED chip.

In one embodiment, there is provided a novel phosphor material, which may be used in the phosphor composition in the above described devices. The phosphor material is a complex fluoride phosphor activated with Mn⁴⁺ and may comprise one or more of (A) A₂[MF₅]:Mn⁴⁺, where A is selected from Li, Na, K, Rb, Cs, NH₄, and combinations thereof; and where M is selected from Al, Ga, In, and combinations thereof; (B) A₃[MF₆]:Mn⁴⁺, where A is selected from Li, Na, K, Rb, Cs, NH₄, and combinations thereof; and where M is selected from Al, Ga, ln, and combinations thereof; (C) Zn₂[MF₇]:Mn⁴⁺, where M is selected from Al, Ga, ln, and combinations thereof; (D) A[In₂F₇]:Mn⁴⁺ where A is selected from Li, Na, K, Rb, Cs, NH₄, and combinations thereof: (E) A₂[MF₆]:Mn⁴⁺, where A is selected from Li, Na, K, Rb, Cs, NH₄, and combinations thereof; and where M is selected from Sn, Zr, and combinations thereof; (F) E[MF₆]:Mn⁴⁺, where E is selected from Mg, Ca, Sr, Ba, Zn, and combinations thereof; and where M is selected from Sn, Zr, and combinations thereof; (G) Ba_{0.65}Zr₀.₃₅F₂.₇₀:Mn⁴⁺; (H) A₃[ZrF₇]:Mn⁴⁺ where A is selected from Li, Na, K, Rb, Cs, NH₄, and combinations thereof; (I) A₂[MF₆]:Mn⁴⁺, where A is selected from at least two among Li, Na, K, Rb, Cs, and NH₄, and where M is selected from Ge, Si, Sn, Ti, Zr, and combinations thereof; or (J) A₂[MF₆]:Mn⁴⁺, where A is selected from Li, Na, K, Rb, Cs, NH₄, and combinations thereof, and where M is selected from at least two among Ge, Si, Sn, Ti, and Zr.

By "complex fluoride phosphor", it is meant that the phosphor is a coordination compound, containing at least one coordination center (e.g. M in the examples above), surrounded by fluoride ions acting as ligands, and charge-compensated by counter ions (e.g. A in the examples above) as necessary. Complex fluorides are occasionally written down as a combination of simple, binary fluorides (e.g.3NaF.AlF₃ instead of Na₃[AlF₆]), but such a representation does not indicate the coordination number (in this example, 6) for the ligands around the coordination center. The square brackets (occasionally omitted for simplicity) indicate that the complex ion they encompass is a new chemical species, different from the simple fluoride ion. The activator ion (Mn⁴⁺) also acts as a coordination center, substituting part of the centers of the host lattice, e.g. Al³⁺. The host lattice (including the counter ions) can further modify the excitation and emission properties of the activator ion.

When used with an LED chip having a peak emission from 250 to 550 nm and one or more additional phosphors (such as blue and green emitting phosphors), the use of the above phosphor material allows for a white LED. The additional phosphors that can be used are described in more detail below.

Exemplary Mn⁴⁺ activated compositions of this embodiment are detailed below in Table 1.

**Table 1**

| **ID#** | **Phosphor** | **Raw materials** |
|---|---|---|
| 1 | K₂[AlF₅]:Mn⁴⁺ | Al(OH)₃, K₂CO₃ K₇[MnF₆] |
| 2 | K₃[AlF₆]:Mn⁴⁺ | Al(OH)₃, K₂CO₃ K₂[MnF₆] |
| 3 | K₃[GaF₆]:Mn⁴⁺ | Ga₂O₃, K₂CO₃ K₂[MnF₆] |
| 4 | Zn₂[AF₇]:Mn⁴⁺ | ZnO, Al(OH)₃ K₂[MnF₆] |
| 5 | K[n₂F₇]:Mn⁴⁺ | In₂O₃, K₂CO₃ K₂[MnF₆] |
| 6 | K₂[SiF₆]:Mn⁴⁺ | K₂[SiF₆] K₂[MnF₆] |
| 7 | K₂[TiF₆]:Mn⁴⁺ | K₂[TiF₆] K₂[MnF₆] |
| 8 | K₃[ZrF₇]:Mn⁴⁺ | K₃[ZrF₇] K₂[MnF₆] |
| 9 | Ba₀.₆₅Zr₀.₃₅F₂.₇₀: Mn⁴⁺ | Zr(OH)₄ BaCO₃ K₂[MnF₆] |
| 10 | Ba[TiF₆]:Mn⁴⁺ | TiO₂ BaCO₃ K₂[MnF₆] |
| 11 | K₂[SnF₆]:Mn⁴⁺ | K₂SnO₃. 3H₂O K₂[MnF₆] |
| 12 | Na₂TiF₆]:Mn⁴ | Na₂[TiF₆] K₂[MnF₆] |
| 13 | Na₂[ZrF₆]:Mn⁴⁺ | Na₂[ZrF₆] K₂[MnF₆] |
| 14 | KRb[TiF₆]:Mn⁴⁺ | K₂[TiF₆], Rb₂[TiF₆] K₂[MnF₆] |
| 15 | K₂[Si_{0.5}Ge_{0.5}F₆]:Mn⁴⁺ | SiO₂, GeO₂, K₂CO₃ K₂[MnF₆] |

Complex fluoride phosphors doped with Mn⁴⁺ with a coordination number of 6 for the coordination center (i.e. in a generally octahedral environment, as in K₂[TiF₆]:Mn⁴⁺) are particularly preferred. Other complex fluorides with higher coordination numbers for the central ion (e.g. K₃[ZrF₇] with a coordination number of 7) are also applicable as host lattices for activation with Mn⁴⁺.

Advantageously, more than one cation can be used in the host lattice (e.g. as shown in Row #14 of Table 1 above and in Example 10 below), to optimize the quantum efficiency of the phosphor. Further, more than one coordination center can be used in the host lattice (e.g. as shown in Row #15 of Table 1 above and in Example 11 below), to broaden the excitation spectrum of the phosphor, thereby making it more suitable for practical use, e.g. with a broader range of LED chips. Preferably, at least two cations and/or at least two coordination centers will be used to optimize the quantum efficiency and the excitation spectrum of the phosphor.

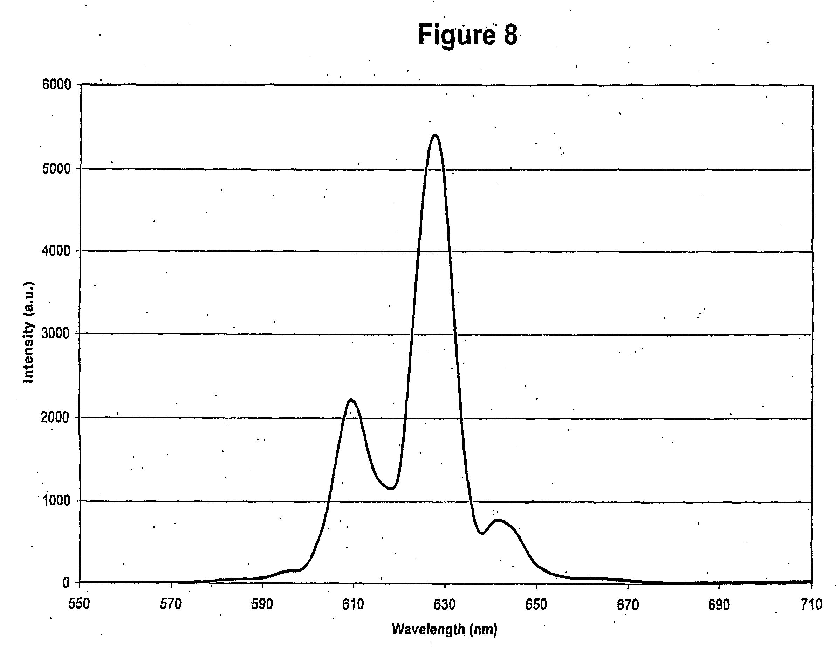

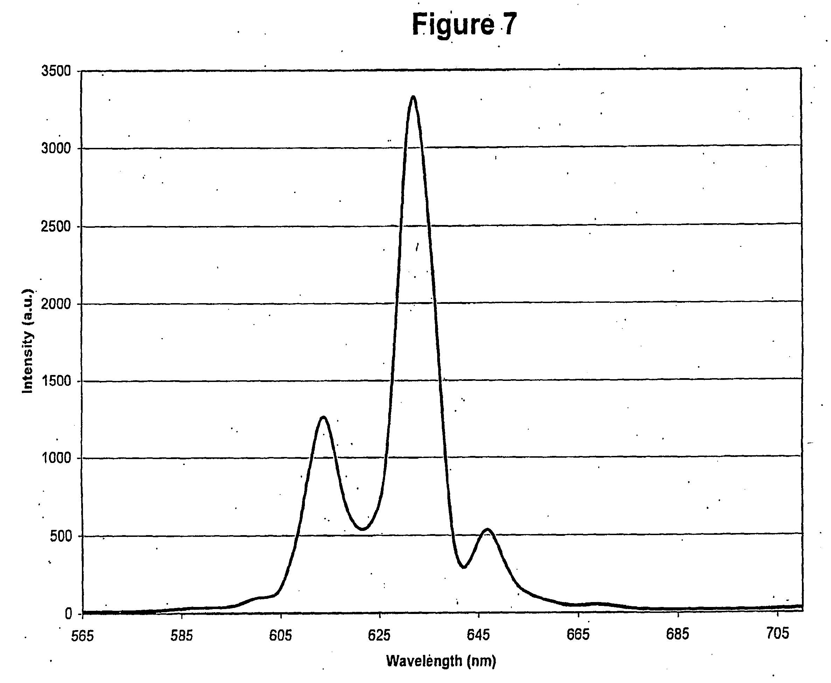

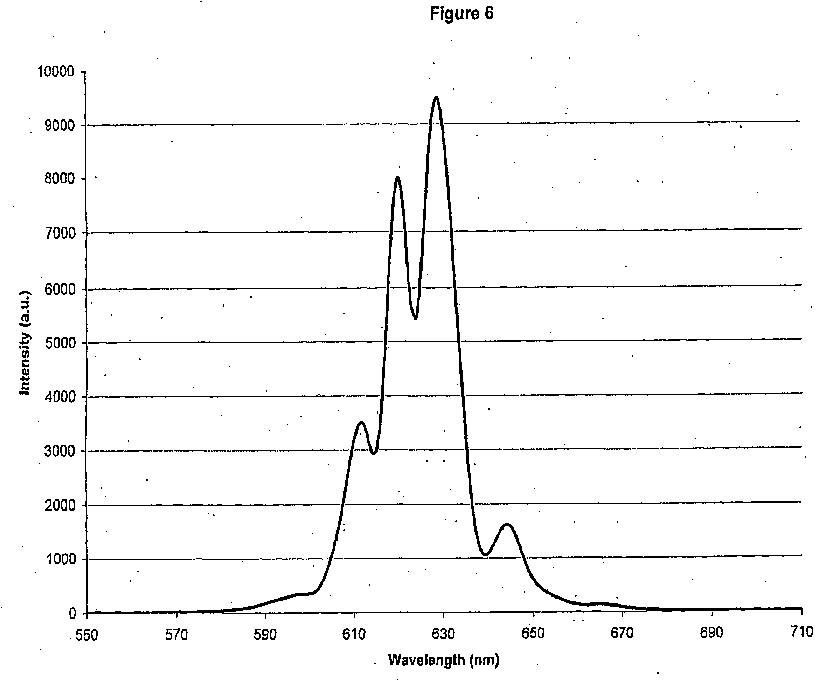

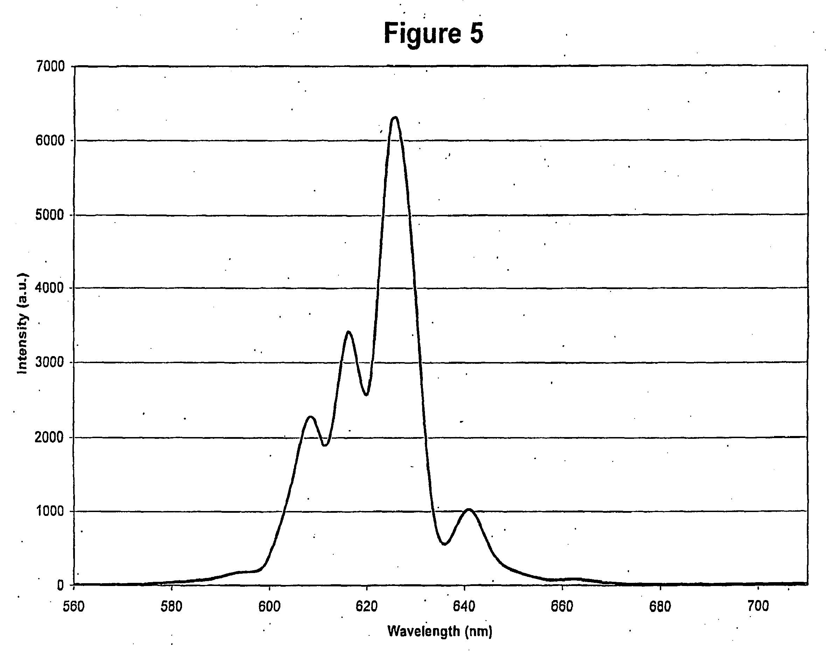

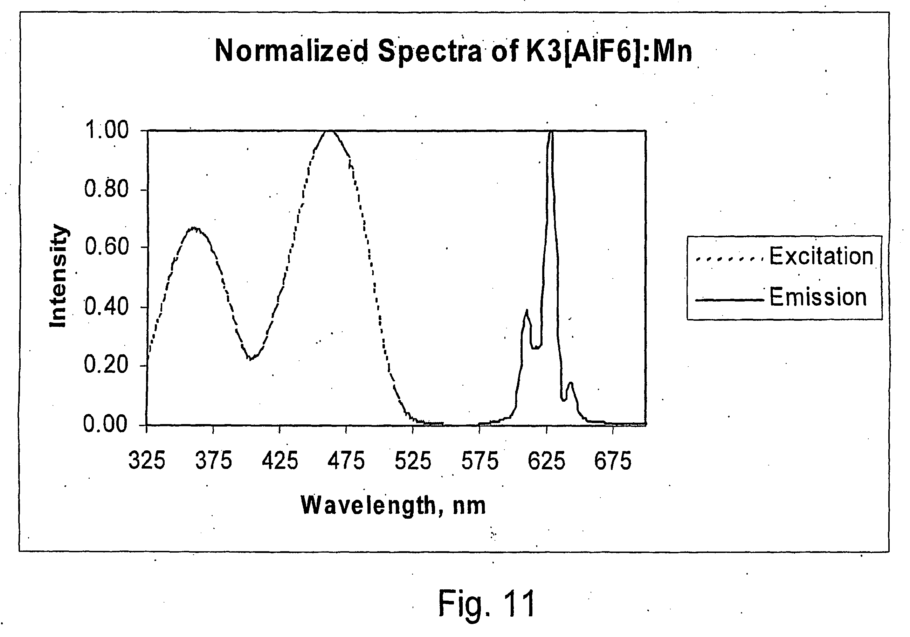

Figures 5-8 show the emission spectra of several of these phosphors when excited by 365 nm UV light. That is, Figure 5 is a graph of the emission spectrum of a Na₂[TiF₆]:Mn⁴⁺ phosphor. Figure 6 is a graph of the emission spectrum of a K₂[SnF₆]:Mn⁴⁺ phosphor. Figure 7 is a graph of the emission spectrum of Ba[TiF₆]:Mn4⁺ phosphor. Figure 8 is a graph of the emission spectrum of a K₃[ZrF₇]:Mn⁴⁺ phosphor. Figure 11 shows the excitation and emission spectra of a K₃[AlF₆]:Mn^{4,1} phosphor.

The above described complex fluoride phosphor compositions activated with Mn⁴⁺ can be prepared by taking appropriate raw materials in a ratio sufficient to ensure the desired incorporation level of the activator ion (e.g. between 0.1 and 30 mol.% of the total M content, more preferably between 2 and 15 mol%). In one embodiment, the raw materials may be dissolved together in aqueous hydrofluoric acid (e.g. 30 to 50% HF by weight) and the phosphor is produced by evaporation of the reaction mixture to dryness in a plastic or Teflon-lined vessel, preferably with continuous heating below the boiling point of the solution - e.g. on a water bath. The crude phosphor may be then milled (preferably dry-milled) to a desired particle size, washed with an organic solvent (e.g. ethanol or acetone) to remove any remaining amounts of HF and dried on the air prior to use in LEDs.

A variety of other starting materials and processes may be used to produce the complex fluoride phosphors in this embodiment via co-crystallization from aqueous solution of HF and/or other fluorides (e.g. prepared *in-situ* or *ex-situ* from oxides, hydroxides, alkoxides, carbonates and binary fluorides or hydrogen fluorides of the metal constituents), and permanganates, or manganates with a stoichiometric amount of H₂O₂ or other peroxide to provide the Mn activator in the proper oxidation state (+4). The examples of complex fluoride phosphors doped with Mn⁴⁺ shown herein are not meant to be limiting. Other constituent ions may be used to build the complex fluoride host lattice (as the coordination center or the counter ion), provided they do not introduce electronic or vibrational transitions deleterious to the phosphor excitation and/or emission upon activation with Mn⁴⁺.

The relative amounts of each phosphor in the phosphor material can be described in terms of spectral weight. The spectral weight is the relative amount that each phosphor contributes to the overall emission spectra of the phosphor blend. The spectral weight amounts of all the individual phosphors should add up to 1. A preferred blend comprises a spectral weight of from 0.01 to 0.80 of a phosphor having a peak emission of from about 500 to 610 nm, from 0 to 0.19 of an optional phosphor having a peak emission from about 430 to 500 nm (which would not be needed for excitation with a blue or blue-green LED having a peak emission from about 430 to about 500 nm), and the balance of the blend being one of the above described complex fluoride phosphors, as needed to achieve the targeted CCT value. Any known phosphors suitable for use in near-UV to green LED systems and emitting in the above wavelength ranges may be used. Garnets activated with at least Ce³⁺ (e.g. YAG:Ce, TAG:Ce and their compositional modifications known in the art) are particularly preferred phosphors with a peak emission at about 500 to 610 nm. Other particularly preferred phosphors having a peak emission in the latter range are alkaline earth silicates activated with at least Eu²⁺, e.g. (Ba,Sr,Ca)₂SiO₄: Eu²⁺ ("BOS") and its compositional modifications known in the art.

It should be noted that various phosphors are described herein in which different elements enclosed in parentheses and separated by commas, such as in the case of (Ba,Sr,Ca)₂SiO₄: Eu²⁺. As understood by those skilled in the art, this type of notation means that the phosphor can include any or all of those specified elements in the formulation in any ratio. That is, this type of notation for the above phosphor, for example, has the same meaning as (Baₐsr_{b}ca_{1-a-b})₂SiO₄: Eu²⁺, where a and b can vary from 0 to 1, including the values of 0 and 1.

As detailed above, an LED backlight device or apparatus may also be produced. As used herein, the terms "device" and "apparatus" are meant to include not only a single LED light or backlight, but also the arrangement of two or more LED backlights on a circuit board or in another type of array.

A red line-emitting phosphor having a peak emission wavelength between 610 and 650 nm may be used to prepare an LED backlight device, in conjunction with at least a green emitting phosphor (e.g. with a peak emission wavelength between 510 and 550 nm) and either a blue LED chip or a blue emitting phosphor (e.g. with a peak emission wavelength between 440 and 480 nm) and a violet to near-UV emitting LED chip (e.g. having a peak emission wavelength from about 370 nm to about 440 nm).

Advantageously, virtually any complex fluoride phosphor activated with Mn⁴⁺ is a suitable example for said red line-emitting phosphor. Non-limiting examples of suitable red line emitting phosphors include the phosphors described herein, as well as those described in parent applications U.S. Patent Applications Nos. 11/364,611, 11/049,598 and 11/285,442, the disclosures of which are incorporated herein by reference in their entirety. A particularly preferred example of such a phosphor is a complex fluoride with coordination number of 6, e.g. A₂[MF₆]:Mn⁴⁺, where A is selected from Li, Na, K, Rb, Cs, NH₄, and combinations thereof; and where M is selected from Ge, Si, Sn, Ti, Zr, and combinations thereof. A non-limiting example of a suitable green emitting phosphor is an alkaline earth thiogallate, thioaluminate or a solid solution thereof activated with Eu²⁺, e.g. strontium thiogallate activated with Eu²⁺ ("STG") SrGa₂S₄:Eu²⁺, and a non-limiting example of a suitable blue-emitting phosphor is strontium chloroapatite activated with Eu²⁺ ("SECA") Sr₅(PO₄)₃Cl:Eu²⁺.

Backlights made with complex fluoride phosphor activated with Mn⁴⁺ can have LER equivalent or better than that of typical blue chip/yellow phosphor LEDs (e.g. greater than 280 Im/Wₒₚₜ at CCTs higher than 5000K). However, unlike the yellow phosphor based LEDs, they will have very little emission in the yellow region of the spectrum which is undesirable for backlighting applications, as explained earlier. Preferably, such backlights will have a gamut greater than 70% that of the NTSC standard, and more preferably greater than 90% that of the NTSC standard in the CIE 1931 x, y diagram.

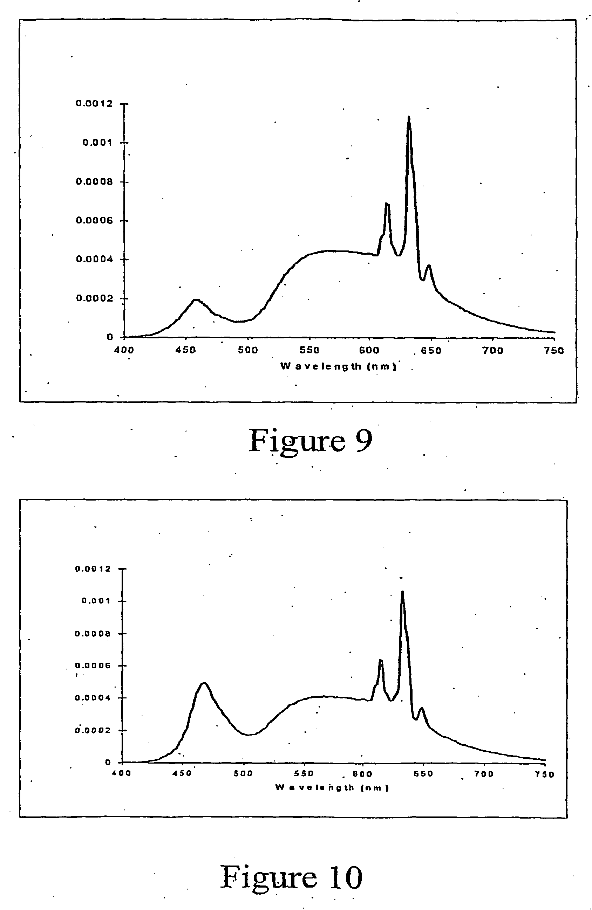

The spectrum of an experimental LED having a CCT of 2900K, Rₐ of 82 and LER of 342 Im/Wₒₚₜ is shown in Fig. 9. The spectrum of a second experimental LED having a CCT of 3500K, Rₐ of 92 and LER of 312 Im/Wₒₚₜ is shown in Figure 10. Both of these LEDs use a blue chip with a terbium aluminum garnet phosphor activated with Ce³⁺ (Tb₂.₉₁Ce₀₋₀₉Al₄.₉₀O_{11.85}) and a red line emitting complex fluoride phosphor (K₂TiF₆]:Mn⁴⁺).

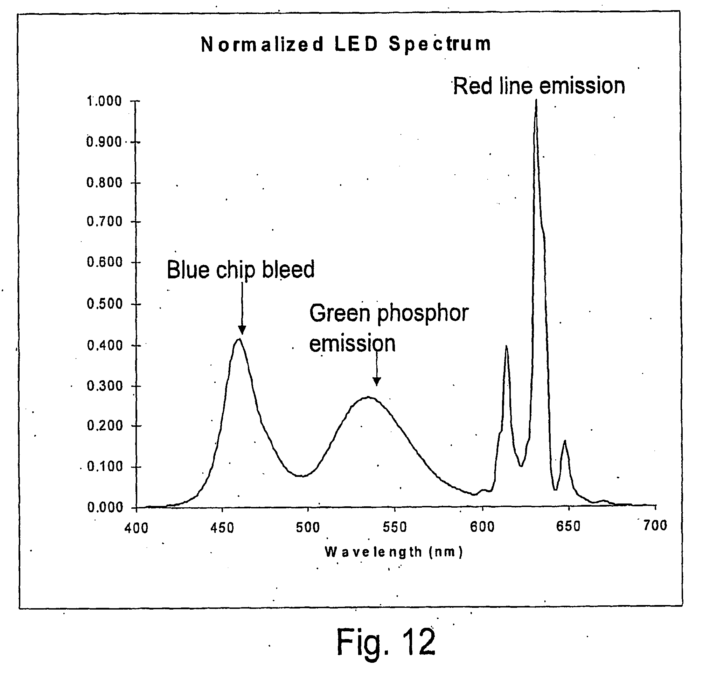

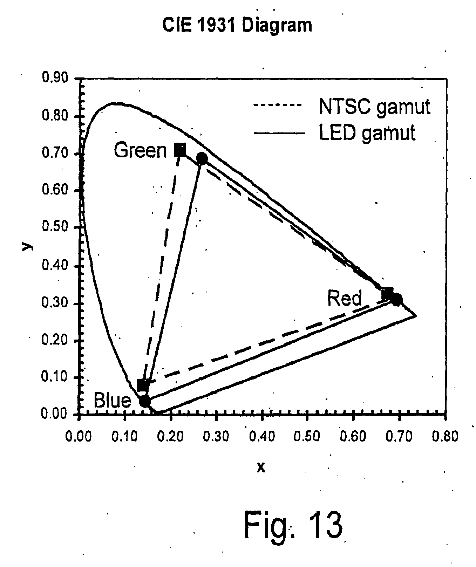

The experimental spectrum of another LED using a blue chip and a blend of the phosphors K₂[TiF₆]:Mn⁴⁺ and STG is shown in Fig. 12. It has chromaticity coordinates x=0.315 and y=0.335 (corresponding to a CCT of 6300K), LER of 292 Im/Wₒₚₜ and a gamut 101% that of NTSC in the CIE 1931 x, y diagram, as shown graphically in Fig. 13.

In addition, other phosphors emitting throughout the visible spectrum region, at wavelengths substantially different from those of the phosphors described in the present invention, may be used in the blend to customize the color of the resulting light and produce sources with improved light quality. While not intended to be limiting, suitable phosphors for use in the blend with the present phosphors include:
(Ba,Sr,Ca)₅(PO₄)₃(Cl,F,Br,OH):Eu²⁺,Mn²⁺
(Ba,Sr,Ca)BPO₅:Eu²⁺,Mn²⁺
(Sr,Ca)₁₀(PO₄)₆*νB₂.3:Eu²⁺ (wherein 0<v≤1)
Sr₂Si₃O₈*2SrCl₂:Eu²⁺
(Ca,Sr,Ba)₃MgSi₂O₈:Eu²⁺,Mn²⁺
BaAl₈O₁₃:Eu²⁺
2SrO*O.84P₂O₅*0.16B₂O₃:Eu²⁺,
(Ba,Sr,Ca)MgAl₁₀O₁₇:Eu²⁺,Mn²⁺
(Ba,Sr,Ca)Al₂O₄:Eu²⁺
(Y,Gd,Lu,Sc,La)BO₃:Ce³⁺,Tb³⁺
(Ba,Sr,Ca)₂Si_{1-ξ}O₄₋₂ξ:Eu²⁺ (wherein 0≤ξ≤0.2)
(Ba,Sr,Ca)₂(Mg,Zn)Si₂O₇:Eu²⁺
(Sr,Ca,Ba)(Al,Ga,In)₂S₄:Eu²⁺
(Y,Gd,Tb,La,Sm,Pr, LU)₃(SC,Al,Ga)₅₋ₐO_{12-3/2a}·Ce³⁺ (wherein 0≤α≤0.5)
(Lu,Sc,Y,Tb)₂₋ᵤ₋ᵥCeᵥCa₁₊ᵤLi_{w}Mg_{2-w}P_{w}(Si,Ge)_{3-w}O_{12-u/2} where -0.5≤u≤1; 0<v≤0.1; and 0≤w≤0.2
(Ca,Sr)₈(Mg,Zn)₈SiO₄)₄Cl₂:Eu²⁺,Mn²⁺
Na₂Gd₂B₂O₇:Ce³⁺,Tb³⁺
(Sr,Ca,Ba,Mg,Zn)₂P₂O₇:Eu²⁺,Mnz⁺
(Gd,Y,Lu,La)₂O₃:Eu³⁺,Bi³⁺
(Gd,Y,Lu,La)₂O₂S:Eu³⁺,Bi³⁺
(Gd,Y,Lu,La)VO₄:Eu³⁺,Bi³⁺
(Ca,Sr)S:Eu²⁺,Ce³⁺
ZnS:Cu⁺,Cl⁻
ZnS:Cu⁺,Al³⁺
ZnS:Ag⁺,Cl⁻
ZnS:Ag⁺,Al³⁺
SrY₂S₄:Eu²⁺
CaLa₂S₄:Ce³⁺
(Ba,Sr,Ca)MgP₂O₇:Eu²⁺,Mn²⁺
(Y,Lu)₂WO₆:Eu³⁺,Mo⁶⁺
(Ba,Sr,Ca)_{β}Si_{y}Nµ:Eu²⁺ (wherein 2β+4y=3µ)
Ca₃(SiO₄)Cl₂:Eu²⁺
(Y,Lu,Gd)_{2-ϕ}Ca_{ϕ}Si₄N_{6+ϕ}C_{1-ϕ}:C_{1-ϕ}Ce³⁺, (wherein 0≤ϕ≤0.5)
(Lu,Ca,Li,Mg,Y)aipha-SiAlON doped with Eu²⁺ and/or Ce³⁺
(Ca,Sr,Ba)SiO₂N₂:Eu²+,Ce3⁺
3.5MgO*0.5MgF₂*GeO₂:Mn⁴⁺
Ca_{1-c-f}Ce_{c}Eu_{f}Al_{1+c}Si_{1-c}N₃, (where 0<c≤0.2, 0≤f≤0.2)
Ca₁₋ₕ₋ᵣCeₕEuᵣAl₁₋ₕ(Mg,Zn)ₕSiN₃, (where 0<h≤0.2, 0≤r≤0.2)
Ca₁₋₂ₛ₋ₜCeₛ(Li,Na)ₛEuₜAISiN₃, (where 0≤s≤0.2, 0≤f≤0.2, s+t>0)
Ca_{1-σ-χ-φ}Ce_{σ}(Li,Na)_{χ}Eu_{φ}Al_{1+σ-χ}Si_{1-σ+χ}N₃, (where 0≤σ≤0.2, 0<χ≤0.4, 0≤φ≤0.2)

For purposes of the present application, it should be understood that when a phosphor has two or more dopant ions (i.e. those ions following the colon in the above compositions), this is to mean that the phosphor has at least one (but not necessarily all) of those dopant ions within the material. That is, as understood by those skilled in the art, this type of notation means that the phosphor can include any or all of those specified ions as dopants in the formulation.

When the phosphor composition includes a blend of two or more phosphors, the ratio of each of the individual phosphors in the phosphor blend may vary depending on the characteristics of the desired light output. The relative proportions of the individual phosphors in the various embodiment phosphor blends may be adjusted such that when their emissions are blended and employed in an lighting device, there is produced visible light of predetermined x and y values on the CIE chromaticity diagram. As stated, a white light is preferably produced. This white light may, for instance, may possess an x value in the range of about 0.30 to about 0.55, and a y value in the range of about 0.30 to about 0.55. Preferably, the color point of the white light will lie on or substantially on the Planckian (also known as the blackbody) locus, e.g. within 0.020 units in the vertical (y) direction of the CIE 1931 chromaticity diagram, more preferably within 0.010 units in the vertical direction. As stated, however, the identity and amounts of each phosphor in the phosphor composition can be varied according to the needs of the end user. Since the efficiency of individual phosphors may vary widely between suppliers, the exact amounts of each phosphor needed are best determined empirically, e.g. through standard design of experiment (DOE) techniques.

It may be desirable to add pigments or filters to the phosphor composition. When the LED is a UV emitting LED, the phosphor layer 22 may also comprise from 0 up to about 10 % by weight (based on the total weight of the phosphors) of a pigment or other UV absorbent material capable of absorbing or reflecting UV radiation having a wavelength between 200 nm and 450 nm.

Suitable pigments or filters include any of those known in the art that are capable of absorbing radiation generated between 200 nm and 450 nm. Such pigments include, for example, nickel titanate or praseodymium zirconate. The pigment may be used in an amount effective to filter 10% to 100% of the radiation generated in the 200 nm to 500 nm range.

### EXAMPLES

### Example 1. Preparation of K₂[TiF₆]:Mn⁴⁺ phosphor

The raw materials (18.48g of K₂[TiF₆], obtained commercially from Fluka and 1.52 g of K₂[MnF₆], prepared according to Bode's method [H.Bode, H.Jenssen, F. Bandte, Angew. Chem., N11(1953), 304] were dissolved in 200 ml of aqueous 40% HF while stirring under heating. The solution was evaporated in a plastic dish on a water bath to dryness. As noted above with reference to Figures 9 and 10, LEDs using a blue chip with a terbium aluminum garnet activated with Ce³⁺ (Tb₂.₉₁Ce₀₋₀₉Al₄.₉₀O_{11.85}) and the present red line emitting phosphor (K₂[TiF₆]:Mn⁴⁺) were produced.

### Example 2. Preparation of Ba[TiF₆]:Mn⁴⁺ phosphor

K₂[MnF₆] (1.34g) was dissolved in 100 ml of aqueous 40% HF with stirring, followed by TiO₂ hydrate (prepared by hydrolysis of tetraisopropyl orthotitanate in distilled water and equivalent to 4.90 g of pure TiO₂ according to the loss on ignition method). Solid BaCO₃ (12.30 g) was then added gradually to the stirred solution. The resulting suspension was evaporated to dryness on a water bath.

### Example 3. Preparation of K₃[ZrF₇]:Mn⁴⁺ phosphor

The raw materials (9.64 g of manufactured K₃[ZrF₇] and 0.36 g of K₂[MnF₆]) were dissolved in 100 ml of aqueous 40% HF while stirring, under heating. The solution was evaporated in a plastic dish on a water bath to dryness.

### Example 4. Preparation of Ba₀.₆₅ Zr₀.₃₅F₂.₇₀: Mn⁴⁺ phosphor

Solid BaCO₃ (11.52 g) and Zr(OH)₄ (9.30 g) were added gradually to 200 ml of aqueous 40% HF with stirring . The slurry was heated for 30 min. on a water bath. The resulting precipitate of Ba₀.₅₅ Zr₀.₃₅ F₂.₇₀ was washed with deionized water through decantation until neutral pH and dried at 100°C. K₂[MnF₆] (1.13 g) was dissolved in 200 ml of aqueous 40% HF suspension of Ba_{0.65} Zr₀.₃₅ F₂.₇₀ (18.87 g) while stirring and then heated on a water bath until a dry residue was formed.

### Example 5. Preparation of K₂[AlF₅]:Mn⁴⁺ phosphor

The raw materials (3.52 g of Al(OH)₃ and 6.23 g of K₂CO₃) are dissolved by careful gradual addition into 40 ml of 50% aqueous HF under heating and stirring of the Teflon dish on a hot plate. The solution is evaporated to dryness to form the K₂[AlF₅] host complex, which is then dissolved in 50 ml of 50% HF along with 0.97 g of K₂[MnF₆], prepared according to Bode's method [H. Bode, H. Jenssen, F. Bandte, Angew. Chem., N11(1953), 304] while stirring under heating. The second solution is evaporated on a water bath to dryness.

### Example 6. Preparation of K₃[AlF₆]:Mn⁴⁺ phosphor

For this phosphor, 2.79 g of AI(OH)₃ and 7.41 g of K₂CO₃ are dissolved by careful gradual addition into 40 ml of 50% aqueous HF under heating and stirring of the Teflon dish on a hot plate. The solution is evaporated to dryness to form the K₃[AlF₆] host complex, which is then dissolved in 50 ml of 50% HF along with 0.77 g of K₂[MnF₆] and evaporated on a water bath to dryness.

### Example 7. Preparation of K₃[GaF₆]:Mn⁴⁺ phosphor

This preparation is carried in the same manner as in the previous example, using 2.91 g of Ga₂O₃ and 6.43 g of K₂CO₃ in the first step (dissolution in 50 ml of 50% HF), followed by 0.67 g of K₂[MnF₆] in the second step.

### Example 8. Preparation of Zn₂[AlF₇]:Mn^{4*} phosphor

This phosphor is prepared by dissolving 2.57g of Al(OH)₃ and 0.34 g of K₂[MnF₆] into 50 ml of 45% HF and the solution is heated to 60oC on a water bath. Then 5.37 g of ZnO is added slowly in small portions, and the formed solution is evaporated to dryness.

### Example 9. Preparation of K[In₂F₇]:Mn⁴⁺ phosphor

A 6.91 g sample of In₂O₃ is dissolved in 100 ml of 50% HF with heating on a water bath and 3.44 g of K₂CO₃ is then added gradually in small portions. The solution is evaporated to dryness on a water bath and the excess KF is removed by precipitation with 100 ml ethanol, followed by filtration. The filtrate is collected, evaporated to dryness and dissolved in 50 ml of 40% HF under heating and stirring, along with 0.51 g of K₂[MnF₆]. The final solution is again evaporated to dryness.

### Example 10. Preparation of KRb[TiF₆]:Mn⁴⁺ phosphor

The following amounts of materials: 5.40 g of Rb₂[TiF₆] (prepared by dissolving 2.40 g of TiO₂ into 50 ml of 40% HF followed by 6.94 g of Rb₂CO₃ added gradually at room temperature, crystallizing via addition of 100 ml absolute ethanol, washing the precipitate with ethanol and then drying it at 100 °C), 3.90 g of K₂[TiF₆] (either prepared in a similar fashion e.g. from 3.33 g of TiO₂ and 5.76 g of K₂CO₃ or obtained commercially), and 0.70 g of K₂[MnF₆] is dissolved in 100 ml of 40% HF. The solution is then evaporated to dryness at 100 °C.

### Example 11. Preparation of K₂[Si_{0.5}Ge₀.₆F₆]:Mn⁴⁺ phosphor

The following amounts of materials: 1.24 g of fumed silica (e.g. Aerosil) and 2.16 g of GeO₂ are dissolved in 100 ml of 40% HF on a hot bath with stirring. Then 5.70 g of K₂CO₃ are added carefully in small portions and the reaction mixture is evaporated to dryness. The dry residue is re-dissolved in 100 ml of 40% HF on a hot bath with stirring, and 0.89 g of K₂[MnF₆] is added to the solution. The final solution is then evaporated to dryness at 100 °C.

Apart from white light blends for general illumination, these phosphors can be used either individually or in blends for LEDs for traffic signals, signage, and particularly for LCD backlighting applications. The narrow red line emission allows for a saturated color that is highly desirable for these applications.

The phosphor materials described above may be used in additional applications besides LEDs. For example, the material may be used as a phosphor in a fluorescent lamp, in a cathode ray tube, in a plasma display device or in a liquid crystal display (LCD). These uses are meant to be merely exemplary and not exhaustive.

The present development has been described with reference to various exemplary embodiments. Modifications and alteration will occur to others upon a reading and understanding of this specification. The invention is intended to include all such modifications and alterations insofar as they come within the scope of the appended claims or the equivalent thereof.

## Claims

1. A lighting apparatus for emitting light comprising:
a light source; and
a phosphor material radiationally coupled to the light source and capable of converting at least a portion of the radiation emitted by the light source into light having a peak emission wavelength between 610 and 650 nm, the phosphor material comprising a complex fluoride phosphor activated with Mn⁴⁺.

2. The lighting apparatus of claim 1, wherein said complex phosphor comprises at least one phosphor selected from the group consisting of:
(A) A₂[MF₅]:Mn⁴⁺, where A is selected from Li, Na, K, Rb, Cs, NH₄, and combinations thereof; and where M is selected from Al, Ga, In, and combinations thereof;
(B) A₃[MF₆]:Mn⁴⁺, where A is selected from Li, Na, K, Rb, Cs, NH₄, and combinations thereof; and where M is selected from Al, Ga, In, and combinations thereof;
(C) Zn₂[MF₇]:Mn⁴⁺, where M is selected from Al, Ga, In, and combinations thereof;
(D) A[In₂F₇]:Mn⁴⁺ where A is selected from Li, Na, K, Rb, Cs, NH₄, and combinations thereof;
(E) A₂[MF₆]:Mn⁴⁺, where A is selected from Li, Na, K, Rb, Cs, NH₄, and combinations thereof; and where M is selected from Ge, Si, Sn, Ti, Zr, and combinations thereof;
(F) E[MF₆]:Mn⁴⁺, where E is selected from Mg, Ca, Sr, Ba, Zn, and combinations thereof; and where M is selected from Ge, Si, Sn, Ti, Zr, and combinations thereof;
(G) Ba_{0.65}Zr_{0.35}F₂.₇₀:Mn⁴⁺; and
(H) A₃[ZrF₇]:Mn⁴⁺ where A is selected from Li, Na, K, Rb, Cs, NH₄, and combinations thereof.

3. The lighting apparatus of claim 1, wherein the light source is a semiconductor light emitting diode (LED) emitting radiation having a peak wavelength in the range of from about 370 to about 500 nm.

4. The lighting apparatus of claim 1, wherein the light source is an organic emissive structure.

5. The lighting apparatus of claim 1, wherein said phosphor material further comprises one or more additional phosphors.

6. The lighting apparatus of claim 5, wherein said one or more additional phosphors is one or more of a garnet activated with Ce³⁺ or an alkaline earth silicate activated with Eu²⁺.

7. The lighting apparatus of claim 5, wherein said one or more additional phosphors are selected from the group including: (Ba,Sr,Ca)₅(PO₄)₃(C),F,Br,OH):Eu²⁺,Mn²⁺; (Ba,Sr,Ca)BPO₅: Eu²⁺, Mn²⁺; (Sr,Ca)₁₀(PO₄)₆*νB₂O₃:Eu²⁺ (wherein 0<ν≤1); Sr₂Si₃O₈*2SrCl₂:EU²⁺; (Ca,Sr,Ba)₃MgSi₂O₈:Eu²⁺,Mn²⁺; BaAl₈O₁₃:Eu²⁺; 2SrO*0.84P₂O₅*0.16B₂O₃:Eu²⁺; (Ba,Sr,Ca)MgAl₁₀O₁₇:Eu²⁺,Mn²⁺; (Ba,Sr,Ca)Al₂O₄:Eu²⁺; (Y,Gd,Lu,Sc,La)BO₃:Ce³⁺,Tb³⁺; ZnS:Cu⁺,Cl⁻; ZnS:Cu⁺,Al³⁺; ZnS:Ag⁺,Cl; ZnS:Ag⁺,Al³⁺; (Ba,Sr,Ca)₂Si_{1-ξ}O_{4-2ξ}:Eu²⁺ (wherein 0≤ξ≤0.2); (Ba,Sr,Ca)₂(Mg,Zn)Si₂O₇:Eu²⁺; (Sr,Ca,Ba)(Al,Ga,In)₂S₄:EU²⁺; (Y,Gd,Tb,La,Sm,Pr,Lu)₃(Al,Ga)_{5-α}O_{12-3/2α}:Ce³⁺ (wherein 0≤α≤0.5); (Ca,Sr)₈(Mg,Zn)(SiO₄)₄Cl₂:Eu²⁺,Mn²⁺; Na₂Gd₂B₂O₇:Ce³⁺,Tb³⁺; (Sr,Ca,Ba,Mg,Zn)₂P₂O₇:Eu²⁺,Mn²⁺; (Gd,Y,Lu,La)₂O₃Eu³⁺,Bi³⁺; (Gd,Y,Lu,La)₂O₂S:Eu³⁺,Bi³⁺; (Gd,Y,Lu,La)V04:Eu³⁺,Bi³⁺; (Ca,Sr)S_{:}Eu²⁺,Ce³⁺; SrY₂S₄:Eu²⁺; CaLa₂S₄:Ce³⁺; (Ba,Sr,Ca)MgP₂O₇:Eu²⁺,Mn²+; (Y,Lu)₂WO₆:Eu³⁺,MO⁶⁺; (Ba,Sr,Ca)_{β}Si_{γ}N_{µ}:Eu²⁺ (wherein 2β+4γ=3µ); Ca₃(SiO₄)Cl₂:Eu²⁺; (Lu,Sc,Y,Tb)₂₋ᵤ₋ᵥCeᵥCa₁₊ᵤLi_{w}Mg_{2-w}P_{w}(Si,Ge)_{3-w}O₁₂O_{12-u/2} (where -0.5≤u≤1, 0<v≤0.1, and 0≤w≤0.2); (Y,Lu,Gd)_{2-ϕ}Ca_{ϕ}Si₄N_{6+ϕ}C_{1-ϕ}:Ce³⁺, (wherein 0≤ϕ≤0.5); (Lu,Ca,Li,Mg,Y)alpha-SiAION doped with Eu²⁺ and/or Ce³⁺; (Ca,Sr,Ba)SiO₂N₂:Eu²⁺,Ce³⁺; 3.5MgO*0.5MgF₂*GeO₂:Mn⁴⁺; Ca_{1-c-f}Ce_{c}Eu_{f}Al_{f}Al_{1+c}Si_{1-c}N₃, (where 0<c≤0.2, 0≤f≤0.2); Ca₁₋ₕ₋ᵣCeₕEuᵣAl₁₋ₕ(Mg,Zn)ₕSiN₃, (where 0<h≤0.2, 0≤r≤0.2); Ca₁₋₂ₛ₋ₜCeₛ(Li, Na)sEuₜAlSiN₃, (where 0≤s≤0.2, 0≤f≤0.2, s+t>0); and Ca_{1-σ-χ-φ}Ce_{σ}(Li,Na)_{χ}Eu_{φ}Al_{1+σ+χ}N₃, (where 0≤σ≤0.2, 0<χ≤0.4, 0≤φ≤0.2).

8. The lighting apparatus of claim 1, having a white light with a CCT of less than 4500K.

9. The lighting apparatus of claim 8, where said white light has a general CRI greater than 90.

10. The lighting apparatus of claim 8, where said white light has a LER greater than 330 Im/Wₒₚₜ.

11. A phosphor material comprising at least one phosphor selected from the group consisting of:
(A) A₂[MF₆]:Mn⁴⁺, where A is selected from Li, Na, K, Rb, Cs, NH₄, and combinations thereof; and where M is selected from Sn, Zr, and combinations thereof;
(B) E[MF₆]:Mn⁴⁺, where E is selected from Mg, Ca, Sr, Ba, Zn, and combinations thereof; and where M is selected from Ge, Si, Sn, Ti, Zr, and combinations thereof;
(C) Ba_{0.65}Zr_{0.35}F_{2.70}:Mn⁴⁺;
(D) A₃[ZrF₇]:Mn⁴⁺ where A is selected from Li, Na, K, Rb, Cs, NH₄, and combinations thereof; and
(E) A₂[MF₆]:Mn⁴⁺, where A is selected from at least two among Li, Na, K, Rb, Cs, and NH₄, and where M is selected from Ge, Si, Sn, Ti, Zr, and combinations thereof.

12. A backlight apparatus comprising a red line-emitting complex fluoride phosphor material activated with Mn⁴⁺ having a peak emission wavelength between 610 and 650 nm; a green emitting phosphor having a peak emission wavelength between 510 and 550 nm; and either a) a blue LED chip having a peak emission wavelength between 440 and 480 nm, or b) a blue emitting phosphor having a peak emission wavelength between 440 and 480 nm and a violet to near-UV emitting LED chip having a peak emission wavelength from about 370 nm to about 440 nm.

## Patentansprüche

1. Beleuchtungsvorrichtung zum Emittieren von Licht mit:
einer Lichtquelle und
einem Luminophormaterial, das strahlend mit der Lichtquelle verbunden ist und das in der ist, mindestens einen der von der Lichtquelle emittierten Strahlung in Licht mit einem Emissionswellenlängenmaximum zwischen 610 und 650 nm umzuwandeln, wobei das Luminophormaterial ein mit Mn⁴⁺ aktiviertes komplexes Fluoridluminophor aufweist.

2. Beleuchtungsvorrichtung nach Anspruch 1, wobei der komplexe Luminophor mindestens einen Luminophor aufweist, der ausgewählt ist aus der Gruppe, die besteht aus:
(A) A₂[MF₅]:Mn⁴⁺, wobei A ausgewählt ist aus Li, Na, K, Rb, Cs, NH₄ und Kombinationen davon und wobei M ausgewählt ist aus Al, Ga, In und Kombinationen davon,
(B) A₃[MF₆]:Mn⁴⁺, wobei A ausgewählt ist aus Li, Na, K, Rb, Cs, NH₄ und Kombinationen davon und wobei M ausgewählt ist aus Al, Ga, In und Kombinationen davon,
(C) Zn₂[MF₇]:Mn⁴⁺, wobei M ausgewählt ist aus Al, Ga, In und Kombinationen davon,
(D) A[ln₂F₇]:Mn⁴⁺, wobei A ausgewählt ist aus Li, Na, K, Rb, Cs, NH₄ und Kombinationen davon,
(E) A₂[MF₆]:Mn⁺⁴, wobei A ausgewählt ist aus Li, Na, K, Rb, Cs, NH₄ und Kombinationen davon und wobei M ausgewählt ist aus Ge, Si, Sn, Ti, Zr und Kombinationen davon,
(F) E[MF₆]:Mn⁴⁺, wobei E ausgewählt ist aus Mg, Ca, Sr, Ba, Zn und Kombinationen davon und wobei M ausgewählt ist aus Ge, Si, Sn, Ti, Zr und Kombinationen davon,
(G) Ba_{0,65}Zr_{0,35}F_{2,70}:Mn⁴⁺ und
(H) A₃[ZrF₇]:Mn⁴⁺, wobei A ausgewählt ist aus Li, Na, K, Rb, Cs, NH₄ und Kombinationen davon.

3. Beleuchtungsvorrichtung nach Anspruch 1, wobei die Lichtquelle eine Halbleiterleuchtdiode (LED) ist, die Strahlung mit einem Wellenlängenmaximum in dem Bereich von ungefähr 370 bis ungefähr 500 nm aufweist.

4. Beleuchtungsvorrichtung nach Anspruch 1, wobei die Lichtquelle eine emittierende organische Struktur ist.

5. Beteuchtungsvorrichtung nach Anspruch 1, wobei Luminophormaterial darüber hinaus ein oder mehrere zusätzliche Luminophore aufweist.

6. Beleuchtungsvorrichtung nach Anspruch 5, wobei das eine oder die mehreren Luminophore eines oder mehrere aus einem mit Ce³⁺ aktivierten Granat oder einem mit Eu²⁺ aktivierten Erdalkalisilikat ist.

7. Beleuchtungsvorrichtung nach Anspruch 5, wobei das eine oder die mehreren zusätzliche Luminophore ausgewählt sind aus der Gruppe, die umfasst: (Ba,Sr,Ca)₅(PO₄)₃(Cl,F,Br,OH):Eu²⁺, Mn²⁺; (Ba,Sr,Ca)BPO₅:Eu²⁺ Mn²⁺; (Sr,Ca)₁₀(PO₄)₆*vB₂O₃:Eu²⁺ (wobei 0<v≤1); Sr₂Si₃O₈*2SrCl₂:Eu²⁺; (Ca,Sr,Ba)₃MgSi₂O₈:Eu²⁺, Mn²⁺; BaAl₈O₁₃:Eu²⁺; 2SrO*0,84P₂O₅*0,16B₂O₃:Eu²⁺; (Ba,Sr,Ca)MgAl₁₀O₁₇:Eu²⁺, Mn²⁺; (Ba,Sr,Ca)Al₂O₄:Eu²⁺; (Y,Gd,Lu,Sc,La)BO₃:Ce³⁺, Tb³⁺; ZnS:Cu⁺, Cl⁻; ZnS:Cu⁺, Al³⁺ ; ZnS:Ag⁺, Cl⁻; ZnS:Ag⁺, Al³⁺; (Ba,Sr,Ca)₂Si_{1-ξ}O_{4-2ξ}:Eu²⁺ (wobei 0 ≤ξ≤0,2); (Ba,Sr,Ca)₂(Mg,Zn)Si₂O₇:Eu²⁺; (Sr,Ca,Ba)(Al,Ga,ln)₂S₄:Eu²⁺; (Y,Gd,Tb,La,Sm,Pr,Lu)₃(Al,Ga)_{5-α}O_{12-3/2α}:Ce³⁺ (wobei 0≤α≤0,5)_{;} (Ca,Sr)₈(Mg,Zn)(SiO₄)₄Cl₂:Eu²⁺, Mn²⁺; Na₂Gd₂B₂O₇:Ce³⁺, Tb³⁺; (Sr,Ca,Ba,Mg,Zn)₂P₂O₇:Eu²⁺, Mn²⁺; (Gd,Y,Lu,La)₂O₃:Eu³⁺, Bi³⁺; (Gd,Y,Lu,La)₂O₂S:Eu³⁺, Bi³⁺; (Gd,Y,Lu,La)VO₄:Eu³⁺, Bi³⁺; (Ca,Sr)S:Eu²⁺, Ce³⁺; SrY₂S₄:Eu²⁺; CaLa₂S₄:Ce³⁺; (Ba,Sr,Ca)MgP₂O₇:Eu²⁺, Mn²⁺; (Y,Lu)₂WO₆:Eu³⁺, Mo⁶⁺; (Ba,Sr,Ca)_{β}Si_{γ}N_{µ}:Eu²⁺ (wobei 2β+4γ=3µ); Ca₃(SiO₄)Cl₂:Eu²⁺; (Lu,Sc,Y,Tb)₂₋ᵤ₋ᵥCeᵥCa₁₊ᵤLi_{w}Mg_{2-w}P_{w}(Si,Ge)_{3-w}O_{12-u/2}) (wobei -0,5≤u≤1, 0<v≤0,1 und 0≤w≤0,2); (Y,Lu,Gd)_{2-ϕ}Ca_{ϕ}Si₄N_{6+ϕ}C_{1-ϕ}:Ce³⁺, (wobei 0≤ϕ≤0,5); (Lu,Ca,Li,Mg,Y)alpha-SiAlON dotiert mit Eu²_{,} und/oder Ce³⁺; (Ca,Sr,Ba)SiO₂N₂:Eu²⁺, Ce³⁺ ; 3,5MgO*0,5MgF₂*GeO₂:Mn⁴⁺; Ca_{1-c-f}Ce_{c}Eu_{f}Al_{1+c}Si_{1-c}N₃, (wobei 0≤c≤0,2, 0≤f≤0,2); Ca₁₋ₕ₋ᵣCeₕEuᵣAl₁₋ₕ(Mg,Zn)ₕSiN₃, (wobei 0≤h≤0,2, 0≤r≤0,2); Ca₁₋₂ₛ₋ₜCeₛ(Li,Na)ₛEuₜAlSiN₃, (wobei 0≤s≤0,2, 0≤f≤0,2, s+t>0) und Ca_{1-σ-X-Φ}Ce_{σ}(Li,Na)_{X}Eu_{Φ}Al_{1+σ+X}N₃, (wobei 0≤σ≤0,2, 0<X≤0,4, 0≤Φ≤0,2).

8. Beleuchtungsvorrichtung nach Anspruch 1 mit einem Weißlicht mit einem CCT von weniger als 4500 K.

9. Beleuchtungsvorrichtung nach Anspruch 8, wobei das Weißlicht einen allgemeinen CRI von größer als 90 aufweist.

10. Beleuchtungsvorrichtung nach Anspruch 8, wobei das Weißlicht einen LER aufweist, der größer ist als 330 Im/Wₒₚₜ.

11. Luminophormaterial mit mindestens einem Luminophor, der ausgewählt ist aus der Gruppe, die gebildet ist aus:
(A) A2[MF₆]:Mn⁴⁺, wobei A ausgewählt ist aus Li, Na, K, Rb, Cs, NH₄ und Kombinationen davon und wobei M ausgewählt ist aus Sn, Zr und Kombinationen davon,
(B) E[MF₆]:Mn⁴⁺, wobei E ausgewählt ist aus Mg, Ca, Sr, Ba, Zn und Kombinationen davon und wobei M ausgewählt ist aus Ge, Si, Sn, Ti, Zr und Kombinationen davon,
(C) Ba_{0,65}Zr_{0,35}F_{2,70}:Mn⁴⁺,
(D) A₃[ZrF₇]:Mn⁴⁺, wobei A ausgewählt ist aus Li, Na, K, Rb, Cs, NH₄ und Kombinationen davon und
(E) A₂[MF₆]:Mn⁴⁺, wobei A ausgewählt ist aus mindestens zwei von Li, Na, K, Rb, Cs und NH₄ und wobei M ausgewählt ist aus Ge, Si, Sn, Ti, Zr und Kombinationen davon.

12. Rückseitenbeleuchtungsvorrichtung mit einem Mn⁴⁺ aktivierten, rote Linien emittierenden komplexen Fluorid-Luminophormaterial mit einem Emissionswellenlängenmaximum zwischen 610 und 650 nm, einem Grün emittierenden Luminophor mit einem Emissionswellenlängenmaximum zwischen 510 und 550 nm und entweder a) einem blauen LED-Chip mit einem Emissionswellenlängenmaximum zwischen 440 und 480 nm oder b) einem Blau emittierenden Luminophor mit einem Emissionswellenlängenmaximum zwischen 440 und 480 nm und einem Violett bis nah-UV emittierenden LED-Chip mit einem Emissionswellenlängenmaximum von ungefähr 370 nm bis ungefähr 440 nm.

## Revendications

1. Dispositif d'éclairage destiné à émettre de la lumière et comprenant :
une source de lumière ; et
un matériau phosphorescent couplé par rayonnement ira source de lumière et apte à transformer au moins une partie du rayonnement émis par la source de lumière en une lumière ayant une longueur d'onde d'émission maximale entre 610 et 650 nm, le matériau phosphorescent comprenant un phosphore à fluorure complexe activé par Mn⁴⁺.

2. Dispositif d'éclairage selon la revendication 1, dans lequel ledit phosphore complexe comprend au moins un phosphore choisi dans le groupe constitué des éléments suivantes :
A) A₂[MF₅]:Mn⁴⁺, où A est choisi parmi Li, Na, K, Rb, Cs, NH₄ et leurs combinaisons et où M est choisi parmi Al, Ga, In et leurs combinaisons ;
B) A₃[MF₆]:Mn⁴⁺, où A est choisi parmi Li, Na, K, Rb, Cs, NH₄ et leurs combinaisons ; et où M est choisi parmi Al, Ga, In et leurs combinaisons ;
C) Zn₂[MF₇]:Mn⁴⁺, où M est choisi parmi Al, Ga, In et leurs combinaisons ;
D) A[In₂F₇]:Mn⁴⁺, où A est choisi parmi Li, Na, K, Rb, Cs, NH₄ et leurs combinaisons ;
E) A₂[MF₆]:Mn⁴⁺, où A est choisi parmi Li, Na, K, Rb, Cs, NH₄ et leurs combinaisons ; et où M est choisi parmi Ge, Si, Sn, Ti, Zr et leurs combinaisons ;
F) E[MF₆]:Mn⁴⁺, où E est choisi parmi Mg, Ca, Sr, Ba, Zn et leurs combinaisons ; et où M est choisi parmi Ge, Si, Sn, Ti, Zr et leurs combinaisons ;
G) Ba_{0,65}Zr_{0,35}F_{2,70}:Mn⁴⁺ ; et
H) A₃[ZrF₇]:Mn⁴⁺, où A est choisi parmi Li, Na, K, Rb, Cs, NH₄ et leurs combinaisons.

3. Dispositif d'éclairage selon la revendication 1, dans lequel la source de lumière est une diode électroluminescente (DEL) à semi-conducteur émettant un rayonnement dont la longueur d'onde maximale va d'environ 370 à environ 500 nm.

4. Dispositif d'éclairage selon la revendication 1, dans lequel la source de lumière est une structure émissive organique.

5. Dispositif d'éclairage selon la revendication 1, dans lequel ledit matériau phosphorescent comprend en outre un ou plusieurs autres phosphores.

6. Dispositif d'éclairage selon la revendication 5, dans lequel lesdits un ou plusieurs autres phosphores sont un ou plusieurs des éléments suivants : un grenat activé par Ce³⁺ ou un silicate alcalinoterreux activé par Eu²⁺.

7. Dispositif d'éclairage selon la revendication 5, dans lequel lesdits un ou plusieurs autres phosphores sont choisis dans le groupe comprenant : (Ba, Sr, Ca)₅(PO₄)₃(Cl, F, Br, OH):Eu²⁺ , Mn²⁺ ; (Ba, Sr, Ca)BPO₅:Eu²⁺, Mn²⁺ ; (Sr, Ca)₁₀(PO₄)₆*vB₂O₃):Eu²⁺ (où 0 < v ≤ 1) ; Sr₂Si3O₈*2SrCl₂:Eu²⁺, (Ca, Sr, Ba)₃MgSi₂O₈:Eu²⁺, Mn²⁺ ; BaAl₈O₁₃:Eu²⁺; 2SrO*0,84P₂O₅*0,16B₂O₃) :Eu²⁺ ; (Ba, Sr, Ca)MgAl₁₀O₁₇:Eu²⁺, Mn²⁺ ; (Ba, Sr, Ca)Al₂O₄:Eu²⁺ ; (Y, Gd, Lu, Sc, La)BO₃: Ce³⁺, Tb³⁺ ZnS:Cu⁺, Cl" ; ZnS:Cu⁺, Al³⁺ ZnS:Ag⁺, Cl⁻; ZnS:Ag⁺, Al³⁺; (Ba, Sr, Ca)₂Si_{1-ξ}O_{4-2ξ}:Eu²⁺ (où 0 ≤ ξ ≤ 0,2) (Ba, Sr, Ca)₂(Mg, Zn)Si₂O₇:Eu²⁺ , (Sr, Ca, Ba)(Al, Ga, In)₂S₄:Eu²⁺ ; (Y, Gd, Tb, La, Sm, Pᵣ, Lu)₃(Al, Ga)_{5-α}O)_{12-3/2α}:Ce³⁺ (où 0 ≤ α ≤ 0,5) ; (Ca, Sr)₈(Mg, Zn)(SiO₄)₄Cl₂:Eu²⁺, Mn²⁺ ; Na₂Gd₂B₂O₇:Ce³⁺ , Tb³⁺ ; (Sr, Ca, Ba, Mg, Zn)₂P₂O₇-Eu²⁺, Mn²⁺ ; (Gd, Y, Lu, La)₂O₃:Eu³⁺, Bi³⁺ ; (Gd, Y, Lu, La)₂O₂S:Eu³⁺Bi³⁺ ; (Gd, Y, Lu, La)VO₄:Eu³⁺, Bi³⁺ ; (Ca, Sr)S:Eu²⁺, Ce³⁺; SrY₂S₄:Eu²⁺; CaLa₂S₄:Ce³⁺; (Ba, Sr, Ca)MgP₂O₇:Eu²⁺, Mn²⁺; (Y, Lu)₂WO6:Eu^{3+,} Mo⁶⁺ ; (Ba, Sr, Ca)_{β}Si_{γ}N_{µ}:Eu²⁺ (où 2β + 4γ = 3µ) ; Ca₃(SiO₄)Cl₂:Eu²⁺; (Lu, Sc, Y, Tb)₂₋ᵤ₋ᵥCeᵥCa₁₊ᵤLi_{w}Mg_{2-w}P_{w-2}P_{w}(Si, Ge)_{3-w}O_{12-u/2} (où -0,5 ≤ u ≤ 1,0 ≤ v ≤ 0,1 et 0 ≤ w ≤ 0,2) ; (Y, Lu, Gd)_{2-ϕ}Ca_{ϕ}Si₄N_{6+ϕ}C_{1-ϕ}:Ce³⁺ (où 0 ≤ ϕ ≤ 0,5) ; (Lu, Ca, Li, Mg, Y) alpha-SiAlON dopé par Eu²⁺ et/ou Ce³⁺; (Ca, Sr, Ba)SiO₂N₂:Eu²⁺, Ce³⁺ ; 3,5MgO*0,5MgF₂*GeO₂:Mn⁴⁺ ; Ca_{1-c-f}Ce_{c}Eu_{f}Al_{1+c}Si_{1-c}N₃ (où 0 < c ≤ 0,2, 0 ≤ f ≤ 0,2) ; Ca₁₋ₕ₋ᵣCeₕEuᵣAl₁₋ₕ(Mg, Zn)ₕSiN₃ (où 0 < h ≤ 0,2, 0 ≤ r ≤ 0,2) ; Ca₁₋₂ₛ₋ₜCeₛ(Li, Na)ₛ EuₜAlSiN₃ (où 0 ≤ s ≤ 0,2, 0 ≤ f ≤ 0,2, s + t > 0) ; et Ca_{1-σ-χ-ϕ}Ce_{σ}(Li, Na)_{χ}Eu_{ϕ}Al_{1+σ-χ}-S_{1-σ+χ}N₃ (où 0 ≤ σ ≤ 0,2, 0 < χ ≤ 0,4, 0 ≤ ϕ ≤ 0,2).

8. Dispositif d'éclairage selon la revendication 1, ayant une lumière blanche d'une température de couleur corrélée inférieure à 4 500 K.

9. Dispositif d'éclairage selon la revendication 8, où ladite lumière blanche a un indice global de rendu des couleurs supérieur à 90.

10. Dispositif d'éclairage selon la revendication 8, où ladite lumière blanche a un rendement lumineux théorique supérieur à 330 Im/Wₒₚₜ.

11. Matériau phosphorescent comprenant au moins un phosphore choisi dans le groupe constitué des éléments suivants :
A) A₂[MF₆]:Mn⁴⁺, où A est choisi parmi Li, Na, K, Rb, Cs, NH₄ et leurs combinaisons ; et où M est choisi parmi Sn, Zr et leurs combinaisons ;
B) E[MF₆]:Mn⁴⁺, où E est choisi parmi Mg, Ca, Sr, Ba, Zn et leurs combinaisons ; et où M est choisi parmi Ge, Si, Sn, Ti, Zr et leurs combinaisons ;
C) Ba_{0,65}Zr_{0,35}F_{2,70}:Mn⁴⁺ ;
D) A₃[ZrF₇]:Mn⁴⁺, où A est choisi parmi Li, Na, K, Rb, Cs, NH₄ et leurs combinaisons ; et
E) A₂[MF₆]:Mn⁴⁺, où A est choisi entre au moins deux éléments parmi Li, Na, K, Rb, Cs et NH₄ et où M est choisi parmi Ge, Si, Sn, Ti, Zr et leurs combinaisons.

12. Dispositif de rétroéclairage comprenant un matériau phosphorescent à fluorure complexe activé par Mn⁴⁺ et émetteur de raie rouge, ayant une longueur d'onde d'émission maximale entre 610 et 650 nm ; un phosphore émettant dans le vert et ayant une longueur d'onde d'émission maximale entre 510 et 550 nm ; et soit a) une puce DEL bleue ayant une longueur d'onde d'émission maximale entre 440 et 480 nm, soit b) un phosphore émettant dans le bleu et ayant une longueur d'onde d'émission maximale entre 440 et 480 nm et une puce DEL émettant depuis le violet jusqu'au proche ultraviolet et ayant une longueur d'onde d'émission maximale allant d'environ 370 nm à environ 440 nm.
